**Europäisches Patentamt**

**European Patent Office**

**Office européen des brevets**

(19)

(11) Numéro de publication : **0 048 689**
**B1**

(12) **FASCICULE DE BREVET EUROPÉEN**

(45) Date de publication du fascicule du brevet :
30.01.85

(21) Numéro de dépôt : **81810333.5**

(22) Date de dépôt : **17.08.81**

(51) Int. Cl.⁴ : **G 01 K   7/32**, H 03 H   3/04,
H 03 H   9/215

(54) **Thermomètre à quartz.**

(30) Priorité : **29.08.80 CH 6508/80**
**21.04.81 CH 2588/81**

(43) Date de publication de la demande :
**31.03.82 Bulletin 82/13**

(45) Mention de la délivrance du brevet :
**30.01.85 Bulletin 85/05**

(84) Etats contractants désignés :
**DE FR GB NL**

(56) Documents cités :
**DE-A- 2 947 721**
**FR-A- 1 372 234**
**FR-A- 2 029 186**
**US-A- 3 423 609**
**US-A- 4 140 999**

(73) Titulaire : **ASULAB S.A.**
**Faubourg du Lac 6**
**CH-2502 Bienne (CH)**

(72) Inventeur : **Dinger, Rudolf**
**Charrières 7**
**CH-2024 St-Aubin (CH)**
Inventeur : **Leuenberger, Claude-Eric**
**Plan 9**
**CH-2000 Neuchâtel (CH)**
Inventeur : **Michel, Jean-Georges**
**Observatoire 44**
**CH-2000 Neuchâtel (CH)**

(74) Mandataire : **Dronne, Guy et al**
**ASUAG Département Brevets et Licences Faubourg du Lac 6**
**CH-2501 Bienne (CH)**

Jouve, 18, rue St-Denis, 75001 Paris, France

0 048 689

## Description

La présente invention concerne un thermomètre à quartz.

De façon plus précise, la présente invention concerne un thermomètre dans lequel l'élément sensible à la température est un résonateur à quartz mis en vibration par un circuit oscillateur de façon à délivrer un signal électrique dont la fréquence est représentative de la température à laquelle est soumis le résonateur.

Les appareils de mesure de la température utilisant un résonateur à quartz comme senseur sont déjà bien connus. Il est en effet bien connu que la fréquence d'un tel résonateur varie avec la température et que la relation entre la fréquence d'oscillation du quartz et la température peut être représentée par l'expression polynomiale suivante :

$$f_T = f_{To} [1 + \alpha(T - To) + \beta(T - To)^2]$$

dans laquelle $f_{To}$ et To sont des constantes, T la température à mesurer, et $f_T$ la fréquence de l'oscillateur à quartz soumis à la température T, $\alpha$ et $\beta$ étant des coefficients indépendants de la température.

Le système de mesure de la température en différents points d'un transformateur qui est décrit dans le brevet américain N° 4 140 999, par exemple, utilise comme éléments sensibles des résonateurs à quartz de coupe DT ou X qui ont des caractéristiques fréquence-température paraboliques. De tels résonateurs peuvent fonctionner à des fréquences relativement basses, inférieures au MHz mais ils sont peu sensibles à la température.

Il en est de même pour le résonateur qui fait l'objet du brevet français N° 1 372 243 et dont il est également question dans le brevet français N° 2 029 186. Ce résonateur qui est réalisé sous forme d'un barreau dont la longueur est parallèle à l'axe X du cristal et dont les faces latérales font avec les deux autres axes Y et Z du quartz un angle d'environ 45°, est excité en torsion et présente également une caractéristique fréquence-température du second degré.

Toutefois il ne suffit pas, en général, que la fréquence dépende de la température T. Il est souvent très souhaitable que cette dépendance soit aussi linéaire que possible. L'avantage essentiel de ce type de thermomètre, par rapport à tous les autres dispositifs connus, réside dans le fait qu'il effectue la conversion directe température-fréquence, c'est-à-dire que l'information sur la température se présente sous une forme quasinumérique. Un autre avantage de ce type de thermomètre est que la fréquence est une grandeur physique qui se mesure avec une résolution aussi grande que cela est désiré si le temps de mesure est augmenté en conséquence.

Il existe déjà sur le marché des thermomètres munis d'une sonde contenant un cristal de quartz vibrant et dont la fréquence dépend de la température de façon très linéaire. Un premier appareil, fabriqué par la Société Hewlett-Packard USA, utilise un quartz de coupe LC excité à une fréquence de 28 MHz. Cet instrument a une sensibilité de l'ordre de 1 000 Hz par °C. Dans l'appareil fabriqué par la société Tokyo Dempa, le quartz oscillant présente une coupe YS et il est excité avec une fréquence de l'ordre de 10 MHz. Cet appareil présente une sensibilité du même ordre de grandeur que celui qui a été cité précédemment.

Ces instruments de haute précision sont cependant très chers et les résonateurs à quartz utilisés comme éléments sensibles ont l'inconvénient d'être très encombrants, car ils sont fabriqués à l'aide d'une technologie ne permettant pas une miniaturisation facile. D'autre part, leur mode de fabrication n'est pas adapté à une production en grande série. Enfin, comme leur mode de vibration correspond à une fréquence égale ou supérieure à 10 MHz, les circuits électroniques qui traitent le signal délivré par le résonateur à quartz consomment une quantité relativement élevée d'énergie électrique.

Pour éviter ces inconvénients, un premier but de l'invention est de fournir un thermomètre à quartz présentant une bonne linéarité en fonction de la température et qui est relativement compact.

Un second but de l'invention est de fournir un tel thermomètre dans lequel le résonateur est aisé à fabriquer par les techniques modernes d'usinage, telles que la gravure chimique.

Un troisième but de l'invention est de fournir un tel thermomètre dans lequel le circuit électronique est relativement simple.

Un quatrième but de l'invention est de fournir un tel thermomètre qui fonctionne à des fréquences plus basses que celles des appareils de l'art antérieur pour diminuer la consommation d'énergie électrique du circuit électronique associé au résonateur.

Un cinquième but de l'invention est de fournir un tel thermomètre dans lequel le résonateur a une capacité dynamique $C_1$ suffisante pour pouvoir faire osciller le résonateur de façon stable avec une faible consommation d'énergie acceptable.

Ces buts sont atteints par les caractéristiques des revendications 1 ou 8. Plus précisément l'invention consiste à utiliser un résonateur à quartz dont la longueur est sensiblement parallèle à l'axe X du cristal de quartz et dont les faces supérieure et inférieure, ou faces principales, sont perpendiculaires à un axe Z' qui fait avec l'axe optique Z du quartz un angle $\theta$ compris soit entre $-30°$ et $+30°$ soit entre $\pm 30°$ et respectivement $\pm 50°$.

Le résonateur est constitué soit par un diapason soit par un barreau et comporte des électrodes qui sont disposées et alimentées de telle manière que ledit résonateur vibre en torsion.

2

Plus précisément, lorsque l'angle θ est compris entre − 30° et + 30° il y a deux électrodes sur la face supérieure d'une branche du diapason ou du barreau et deux sur sa face inférieure, ces électrodes étant disposées parallèlement à la longueur du résonateur. Par contre si l'angle θ est compris entre − 30° et − 50° ou entre + 30° et + 50° il y a au moins une électrode disposée parallèlement à la longueur du résonateur sur chaque face et sur chaque flanc des branches du diapason ou du barreau.

Par ailleurs, le rapport entre l'épaisseur e et la largeur w du barreau ou de chaque branche du diapason est compris entre 0,1 et 0,8.

Grâce à cela, le résonateur délivre un signal dont les variations de fréquence sont une fonction sensiblement linéaire de la température.

Par linéaire, il faut entendre que dans la relation polynomiale entre la fréquence et la température, le coefficient α du premier degré est très supérieur au coefficient β. Cela ne signifie pas nécessairement que le coefficient β est nul. Par exemple le rapport entre les deux est de l'ordre de $10^2$ à $10^3$.

Ces objets et avantages de l'invention ainsi que d'autres encore apparaîtront plus clairement à la lecture de la description qui suit de plusieurs modes préférés de réalisation de l'invention. La description se réfère aux dessins annexés, sur lesquels :

la figure 1 est une vue en perspective d'un premier résonateur en forme de diapason utilisable dans l'invention, la figure faisant en outre apparaître les différents paramètres de définition du diapason :

la figure 1a représente le diapason selon le plan de coupe A-A de la figure 1 ;

la figure 2 est une vue en perspective d'un premier barreau de quartz utilisable dans l'invention, la figure faisant en outre apparaître les différents paramètres de définition du barreau ;

la figure 3 montre des courbes donnant le coefficient de température α du premier ordre et β du deuxième ordre d'un résonateur excité en torsion pour un angle de coupe θ = + 2° avec l'axe optique Z du quartz en fonction du rapport e/w des dimensions de l'épaisseur et de la largeur de l'élément en quartz ;

la figure 4 représente un exemple de réalisation du circuit électrique de traitement des signaux délivrés par le résonateur ;

les figures 5a et 5b montrent des diagrammes des temps expliquant le fonctionnement du circuit de traitement ;

la figure 6 représente des courbes de réglage du thermomètre ;

la figure 7 représente en perspective un deuxième résonateur à quartz en forme de diapason, utilisable dans l'invention ;

la figure 7a représente le diapason de la figure 7 selon le plan de coupe A-A de cette figure ;

la figure 8 représente un deuxième mode de réalisation d'un barreau utilisable dans l'invention ;

la figure 9 est une courbe représentant le rapport e/w, en fonction de l'angle de coupe θ pour β = 0 ; et

la figure 10 est une courbe donnant les valeurs de α en fonction de l'angle θ pour β = 0.

Comme cela a déjà été expliqué, le thermomètre de l'invention comprend d'une part un résonateur à quartz dont les électrodes sont localisées et alimentées pour exciter en torsion l'élément en quartz et d'autre part un circuit électronique pour afficher la température mesurée par le résonateur.

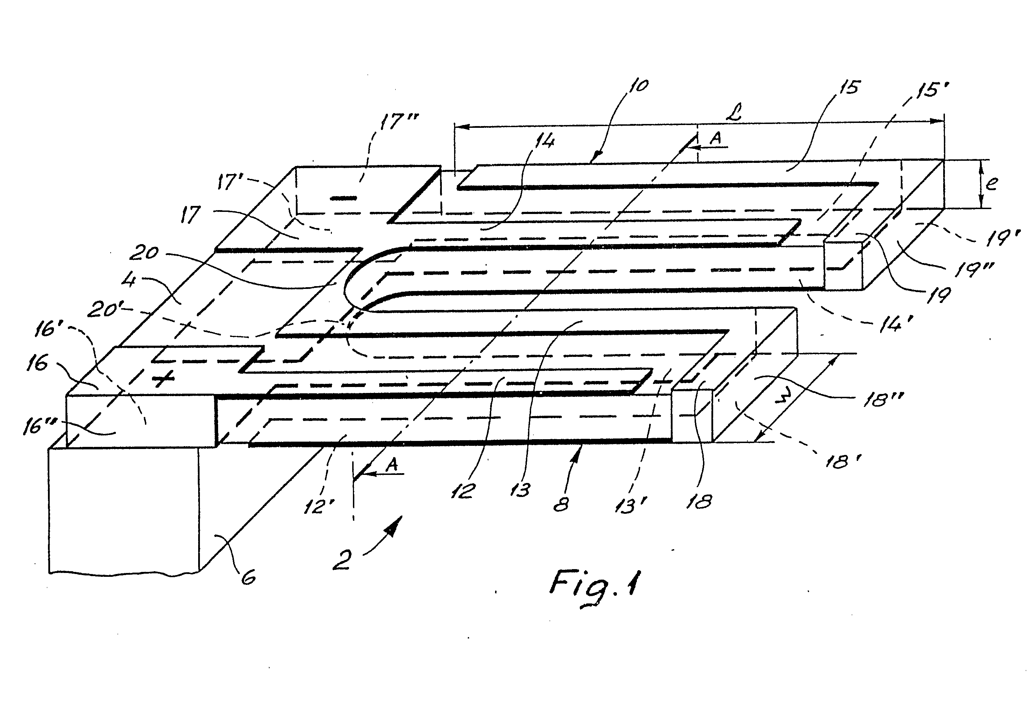

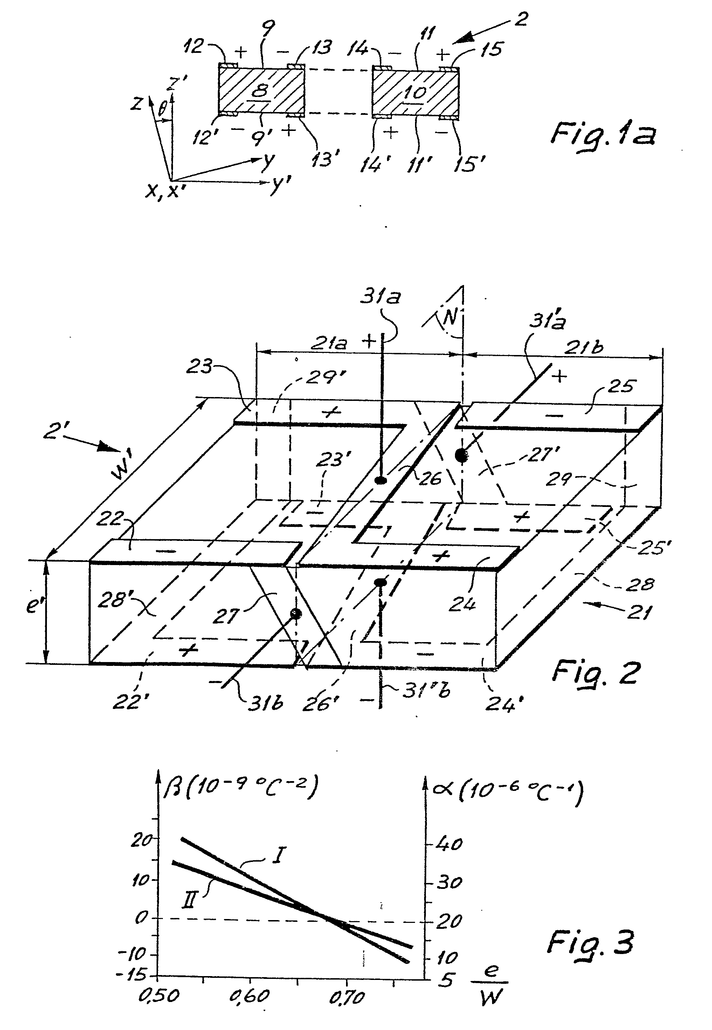

En se référant aux figures 1, 1a et 3, il va d'abord être décrit un premier mode de réalisation de l'invention selon lequel le résonateur est constitué par un diapason 2 en quartz. Le diapason 2 comprend une embase 4 par laquelle il est fixé sur le piédestal 6. Il comprend, bien sûr, également deux branches 8 et 10 dont la section droite est sensiblement rectangulaire. Cette section droite présente un petit côté de longueur e ou épaisseur du diapason et un grand côté w ou largeur de la branche du diapason. Chaque branche du diapason 8 et 10 a ainsi la forme d'un parallélépipède rectangle.

Sur la figure 1, les directions correspondant à la longueur L, la largeur W et l'épaisseur e d'une branche du diapason sont respectivement repérées par les axes X', Y' et Z'. La figure 1a montre de plus l'orientation des axes X', Y' et Z' du résonateur par rapport aux axes optiques X, Y et Z du quartz.

Selon l'invention, le diapason est taillé de telle manière que sa longueur soit disposée sensiblement selon l'axe optique X du quartz, c'est-à-dire que les directions X et X' sont sensiblement confondues. En revanche, l'axe Z' du diapason fait un angle θ avec l'axe optique du quartz. Il en va bien sûr de même pour l'axe Y' par rapport à l'axe Y.

Ainsi que cela a déjà été expliqué, le diapason doit être excité en torsion. Pour cela, des métallisations sont déposées sur les faces 9, 9' et 11, 11' correspondant à la largeur w des branches du diapason.

Plus précisément pour chaque branche du diapason, chaque face est munie de deux électrodes parallèles à la longueur des bras et disposées sur les bords des faces, c'est-à-dire à proximité des flancs de chaque branche. Comme le montre la figure 1a la face 9 de la branche 8 est munie des électrodes 12 et 13 tandis que la face 9' est munie des électrodes 12' et 13'. De façon similaire les faces 11 et 11' de la branche 10 sont munies respectivement des électrodes 14 et 15, et 14' et 15'. En outre les électrodes de la même face d'une branche sont portées à des potentiels différents et les électrodes d'une même branche se faisant face sont également portées à des potentiels différents. Enfin les deux électrodes intérieures d'une même face (supérieure ou inférieure) sont au même potentiel. Ainsi sur la figure 1a les électrodes 12, 13', 14' et 15 sont portées à un potentiel positif alors que les électrodes 12', 13, 14 et 15' sont portées à un potentiel négatif, les deux branches 8 et 10 du diapason vibrant ainsi en torsion.

3

Cette disposition permet, de plus, de faire vibrer antisymétriquement les branches 8 et 10 du diapason afin de compenser leurs moments cinétiques respectifs.

La figure 1 montre un mode concret de réalisation des métallisations conductrices pour former les électrodes ainsi que les connexions entre les électrodes devant être portées au même potentiel. Cette figure ne respecte pas les proportions entre les dimensions du diapason afin de rendre plus lisible l'implantation des métallisations. Les électrodes 12 et 14 sont prolongées au niveau de l'embase 4 par des dépôts conducteurs 16 et 17 formant des plots de connexions aux potentiels positif et négatif. Les électrodes 13 et 15 sont prolongées par des métallisations 18 et 19 disposées aux extrémités libres des branches du diapason. En outre une métallisation 20 relie entre elles les électrodes 13 et 14. Sur les faces inférieures des branches les métallisations ont une disposition correspondante. Les électrodes 13' et 15' sont prolongées par des dépôts conducteurs 16' et 17' au niveau de l'embase 4. Les électrodes 12' et 14' sont prolongées par des métallisations 18' et 19' faisant face aux métallisations 18 et 19. Enfin l'électrode 13' est reliée à l'électrode 14' par la métallisation 20'. La liaison électrique entre les métallisations sur les deux faces est réalisée par des métallisations sur les flancs et les extrémités des branches et de l'embase. Plus précisément les métallisations 18 et 18' sont réunies par la métallisation 18'' tandis que les métallisations 19 et 19' sont réunies par la métallisation 19''. Au niveau de l'embase 4 les métallisations 16 et 16' sont réunies par la métallisation 16'' tandis que les métallisations 17 et 17' sont réunies par la métallisation 17''. Ces métallisations sont réalisées de façon classique par dépôt d'une couche de chrome et d'une couche d'or, ou bien une couche d'aluminium ou autre métal. Il est intéressant d'observer que les seules métallisations à réaliser sur les flancs ne forment pas les électrodes proprement dites et qu'en outre les zones où ces métallisations doivent être faites sont aisément accessibles (extrémité de branches, flancs de l'embase). La réalisation d'ensemble des métallisations ne pose donc pas de problème majeur.

Par ailleurs, pour obtenir une bonne linéarité entre la température et la fréquence délivrée par le thermomètre, il est nécessaire de choisir d'une part l'angle θ et d'autre part la valeur du rapport e/w dans certaines fourchettes. Pour optimiser la linéarité de la réponse au sens défini précédemment, il faut de plus respecter une relation entre la valeur choisie pour θ et la valeur du rapport e/w.

Plus précisément, avec le type d'électrodes choisies, il faut que l'angle θ soit compris entre − 30° et + 30°. Il faut, par ailleurs, que le rapport e/w soit compris entre 0,4 et 0,8.

La figure 3 donne, pour θ = + 2° ; la valeur du coefficient β exprimé en $10^{-9}$ °C$^{-2}$ (courbe I) et du coefficient α exprimé en $10^{-6}$ °C$^{-1}$ (courbe II) pour différentes valeurs du rapport e/w. Ces courbes montrent qu'il est possible de réaliser un résonateur dans lequel le coefficient est nul. La réponse du thermomètre est alors parfaitement linéaire. Ces courbes montrent encore qu'il est possible de choisir le rapport e/w de telle manière que le coefficient β reste faible tout en ayant une valeur élevée de α c'est-à-dire un thermomètre très sensible.

En outre la longueur L des branches du diapason est choisie pour que la fréquence du diapason soit de l'ordre de quelques centaines de kHz typiquement un multiple de 32,738 kHz qui est la fréquence des quartz utilisés comme base de temps.

A titre d'exemple, il a été réalisé un thermomètre avec un quartz diapason excité en torsion présentant les caractéristiques suivantes :

θ = + 2°
W = 0,230 mm
e = 0,125 mm
e/w = 0,55
L = 2,75 mm (longueur d'une branche du diapason).

Dans ce cas, la fréquence d'excitation est de 262,144 kHz et les coefficients de température de ce thermomètre sont :

α = 35 · $10^{-6}$ °C$^{-1}$
β = 20 · $10^{-9}$ °C$^{-2}$.

Il est important d'observer que la coupe avec θ = + 2° correspond aux coupes classiquement utilisées pour réaliser les résonateurs à quartz constituant la base de temps des montres électroniques. Un tel usinage est donc parfaitement maîtrisé par exemple par attaque chimique. En outre la capacité dynamique de ce diapason est de 0,33 fF ce qui est élevé pour un quartz vibrant en torsion. Il faut également relever que la fréquence d'oscillation de 262,144 kHz est très basse par rapport aux fréquences de quelques MHz auxquelles vibrent les résonateurs connus des thermomètres selon l'art antérieur. Enfin le résonateur présente une très bonne linéarité dans sa dépendance vis-à-vis de la température au sens où il faut entendre cette expression dans le présent texte. En effet si β n'est pas nul, le rapport α/β vaut 1,75 · $10^3$. L'effet du terme du premier degré est donc largement prépondérant par rapport au terme du second degré. Cependant la valeur absolue de α est très élevée 35 · $10^{-6}$ C$^{-1}$, ce qui assure une très forte sensibilité à la température. Les deux conditions pour avoir un bon capteur thermométrique sont donc réunies.

La figure 3 montre qu'en choisissant un rapport e/w égal à 0,68 on obtient un coefficient β qui est nul et un coefficient α qui vaut un peu plus de 20 · $10^{-6}$ °C$^{-1}$. Il s'agit donc encore d'une valeur de α très acceptable.

On a indiqué précédemment que l'angle θ pouvait être compris entre − 30° et + 30°. Il faut cependant préciser qu'en se limitant à une fourchette − 10° et + 10° on conserve les propriétés thermiques tout en restant dans des angles de coupe relativement proches de la coupe Z. Il s'agit donc de résonateurs qui peuvent être aisément usinés par attaque chimique. En outre en adoptant un angle θ légèrement négatif par exemple entre 0° et − 10°, et en conservant un rapport e/w dans le domaine déjà défini il est possible d'obtenir un coefficient β nul ou sensiblement nul avec un coefficient α nettement supérieur à $20 \cdot 10^{-6}\,°C^{-1}$, par exemple de l'ordre de au moins $30 \cdot 10^{-6}\,°C^{-1}$.

En outre lorsqu'on indique que la longueur du diapason est sensiblement parallèle à l'axe X, cela signifie que pour définir le plan du diapason, après la rotation de l'angle θ autour de l'axe X il peut y avoir une rotation d'un angle réduit autour de OY'.

La figure 2 montre un autre résonateur utilisable dans le thermomètre selon l'invention. Le résonateur 2' a la forme d'un barreau parallélépipèdique de largeur w' et d'épaisseur e'.

Le barreau 21 en quartz a sa longueur disposée selon l'axe X du quartz et la perpendiculaire Z' à ses faces supérieure et inférieure fait un angle θ compris entre + 30° et − 30° avec l'axe Z du quartz.

Les électrodes sont disposées sur les deux demi-barreaux 21a et 21b séparés fictivement par le plan nodal N représenté en traits mixtes. Les électrodes 22 et 23 sont disposées sur la face supérieure du demi-barreau 21a à proximité de ses bords. De même les électrodes 22' et 23' sont disposées sur la face inférieure du demi-barreau 21a en regard respectivement des électrodes 22 et 23. Pour le demi-barreau 21b, on trouve les électrodes 24 et 25 sur la face supérieure et les électrodes 24' et 25' sur la face inférieure en regard des électrodes 24 et 25. Pour que le barreau vibre en torsion, il faut que pour chaque demi-barreau il y ait la même disposition d'électrodes que pour une branche du diapason 2 et que de plus les deux électrodes symétriques par rapport au plan nodal N soient portées à des potentiels opposés. Pour cela, les électrodes 23 et 24 sont reliées par la métallisation 26 coupant le plan nodal, et les électrodes 23' et 24' sont reliées par la métallisation 26' qui coupe également le plan nodal. En outre les électrodes 22 et 24' sont reliées par la métallisation 27 qui coupe le plan nodal et les électrodes 23 et 25' sont reliées par la métallisation 27' qui coupe également le plan nodal. Les métallisations 27 et 27' sont disposées sur les flancs du barreau. Enfin, les électrodes 24' et 25 sont reliées par les métallisations 28 et 29 disposées sur la face inférieure et sur un flanc à proximité de l'extrémité du demi-barreau 21b, alors que les électrodes 22' et 23 sont reliées par les métallisations 28' et 29' disposées sur la face inférieure et sur un flanc à proximité de l'extrémité du demi-barreau 21a.

Enfin les fils conducteurs 31a et 31'a sont fixés sur les métallisations 26 et 27' pour porter les électrodes 22', 23, 24 et 25' à un potentiel négatif. Les fils conducteurs 31a, 31'a, 31b et 31'b sont tous disposés dans le plan nodal du barreau en quartz vibrant en torsion pour assurer le supportage du barreau de quartz.

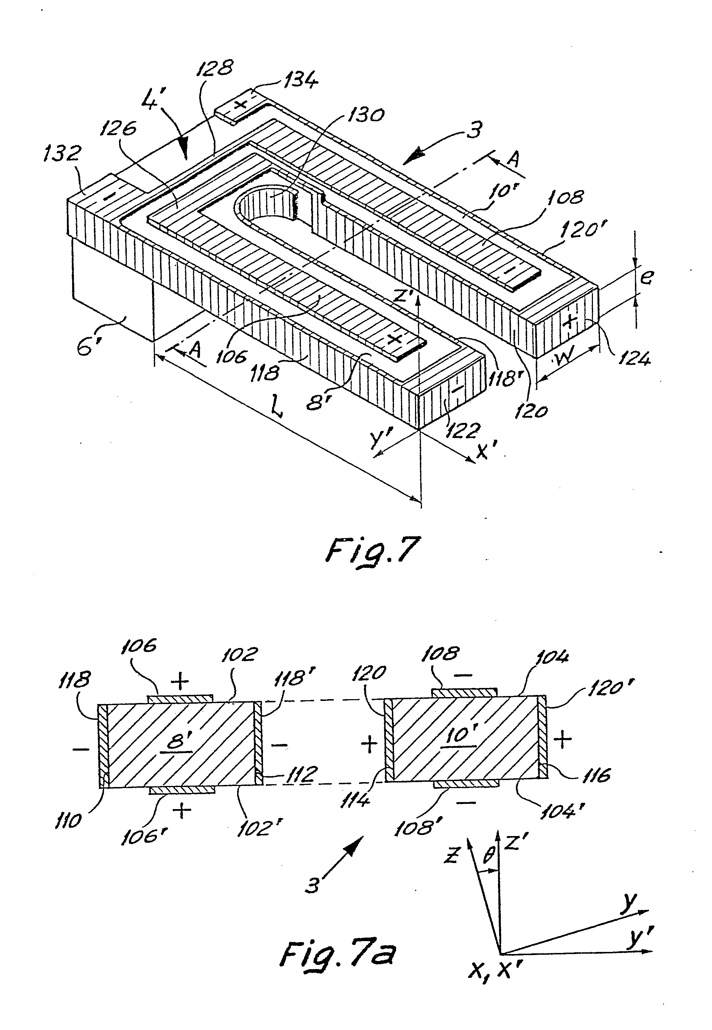

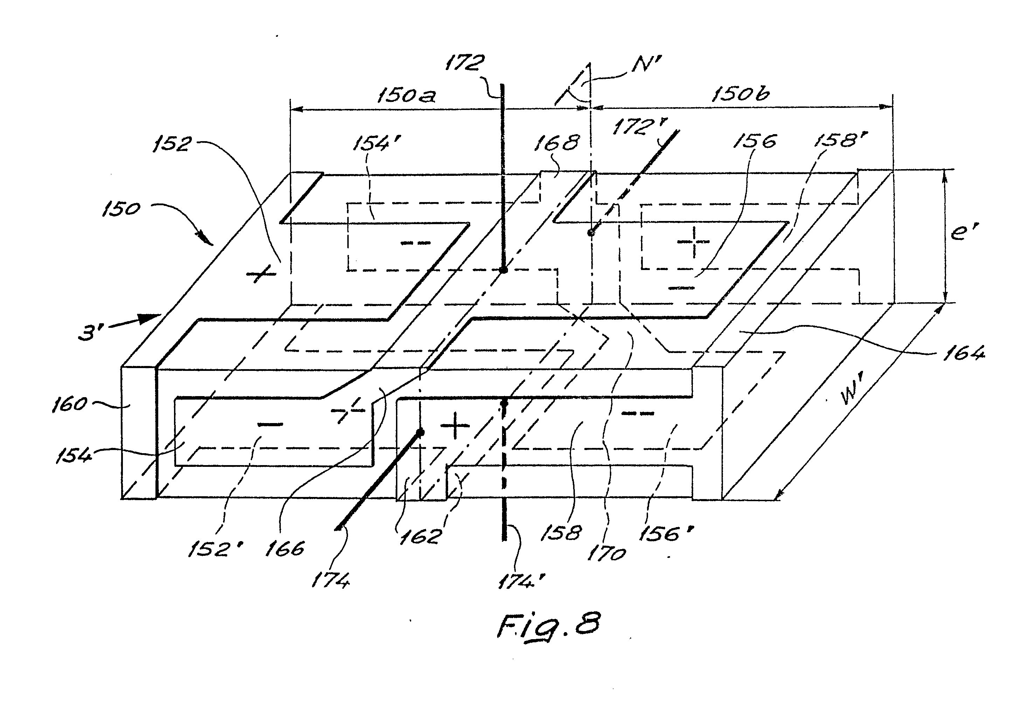

Les figures 7, 7a et 8 montrent un deuxième mode de réalisation du résonateur pour le thermomètre dans lequel on utilise une autre plage d'angle de coupe associée à une autre disposition des électrodes.

Les figures 7 et 7a concernent le cas où le résonateur 3 a la forme d'un diapason. Le diapason comprend bien entendu une embase 4' par laquelle il est fixé sur le support 6', et deux branches 8' et 10' qui sont sensiblement parallèles à l'axe X du quartz. Comme on le voit mieux sur la figure 7a, les faces supérieures 102 et 104 et inférieures 102' et 104' des branches 8' et 10' du diapason sont munies d'électrodes longitudinales référencées respectivement 106, 108 et 106', 108'. De même les flancs 110 et 112 de la branche 8' et les flancs 114 et 116 de la branche 10' sont munis respectivement des électrodes 118, 118' et 120, 120'. Pour chaque branche les électrodes qui se font face sont portées à un même potentiel, et les électrodes occupant une position sur la branche 8' sont portées à un potentiel différent des électrodes occupant la même position sur l'autre branche. Par exemple les électrodes 106, 106', 120 et 120' sont portées au potentiel positif et les électrodes 118, 118', 108 et 108' sont portées au potentiel négatif. On obtient ainsi une vibration, en torsion du résonateur. De plus les branches 8' et 10' vibrent antisymétriquement ce qui permet de compenser leurs moments cinétiques respectifs.

La figure 7 montre un mode de réalisation des métallisations pour obtenir les électrodes et les connexions électriques entre ces électrodes. Sur cette figure les électrodes 106' et 108' des faces inférieures ne sont pas visibles. Les électrodes des faces supérieures et inférieures s'arrêtent avant l'extrémité des branches 8' et 10' pour permettre la réalisation des métallisations 122 et 124 sur les extrémités de ces branches, ces métallisations pouvant légèrement déborder sur les faces supérieures et inférieures. La métallisation 122 relie entre elles les électrodes 118 et 118' tandis que la métallisation 124 relie entre elles les électrodes 120 et 120'. La métallisation 126 relie les électrodes 106 et 120 et la métallisation 128 les électrodes 108 et 118. La métallisation 130 relie l'électrode 118' à l'électrode 108' non visible sur la figure 7. Enfin une métallisation non visible déposée sur la face inférieure de l'embase 4' relie les électrodes cachées 106' et l'électrode 120'. Sur la face supérieure de l'embase 4' les plots de contact 132 et 134 sont respectivement reliés aux électrodes 118 et 120'. En reliant le contact 132 à une tension négative et le contact 134 à une tension positive, on réalise les polarisations d'électrodes représentées sur la figure 7a.

La figure 8 montre la structure du résonateur 3' en forme de barreau selon le deuxième mode de réalisation. Sur cette figure les rapports entre la largeur w' l'épaisseur e' et la longueur du barreau ne correspondent pas à la réalité pour rendre plus lisible la figure. Le barreau 150 est fonctionnellement divisé en deux demi-barreaux 150a et 150b par le plan nodal N'. Pour le demi-barreau 150a, on trouve les électrodes 152, 152' et 154, 154' respectivement disposées sur les faces et les flancs du demi-barreau. De

**0 048 689**

même le demi-barreau 150b comporte sur ses faces les électrodes 156 et 156' et sur ses flancs les électrodes 158 et 158'. Les électrodes 152 et 152' sont réunies par la métallisation 160. Les électrodes 152' et 158 sont réunies par la métallisation 162, et les électrodes 158 et 158' sont réunies par la métallisation 164 disposée à l'extrémité de la face supérieure du demi-barreau 150b. De même les électrodes 156 et 154 sont réunies par la métallisation 166 ; les électrodes 156 et 154' par la métallisation 168 ; et les électrodes 154' et 156' par la métallisation 170. Ainsi le demi-barreau 150a a la même structure d'électrodes que la branche 8' du diapason et le demi-barreau 150b la même structure que la branche 10'. L'alimentation électrique et le supportage du barreau sont réalisés par quatre fils conducteurs disposés dans le plan nodal. Plus précisément, les fils 172 et 172' sont soudés sur les électrodes 156 et 154' et reliés à un potentiel négatif tandis que les fils 174 et 174' sont soudés sur les électrodes 158 et 152' et reliés à un potentiel positif.

Avec cette disposition d'électrodes, l'angle de coupe θ doit avoir d'autres valeurs pour obtenir un couplage piézo-électrique utilisable. Dans ce cas l'angle θ est compris entre − 50° et − 30° ou entre + 30° et + 50°. Il est clair que ces limites ne sont pas absolues mais correspondent à des modes de réalisation intéressants. Pour ce même type d'électrodes le rapport e/w peut être compris entre 0,1 et 0,8. Comme dans le cas des modes de réalisation des figures 1 et 1a les paramètres θ, et e/w peuvent être choisis soit pour rendre β nul tout en ayant une valeur acceptable de α, soit pour rendre le rapport entre α et β très grand, β étant faible mais non nul.

A titre d'exemple, on peut considérer le quartz diapason suivant ayant le système d'électrodes représenté sur les figures 7a, 7b.

$\theta = - 40°$

$e/w = 0,3$

$\alpha = 50 \cdot 10^{-6}/°C$

$\beta = 0.$

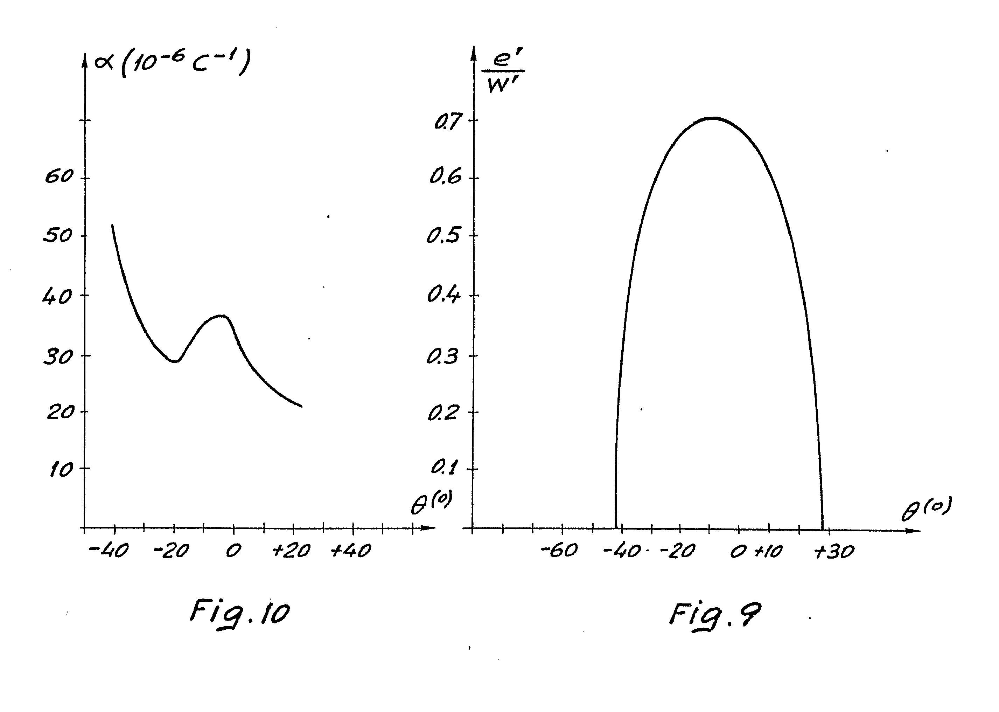

Plus généralement, les courbes des figures 9 et 10 correspondent au cas où il est imposé que β soit nul, c'est-à-dire au cas où il est imposé que la relation entre la température et la fréquence soit strictement linéaire. La courbe 9 montre qu'il est possible d'obtenir une valeur nulle de β pour des valeurs de θ comprises entre − 42° et + 28° et de e/w comprises entre 0 et 0,7. La courbe de la figure 10 montre que pour cette plage d'angle de coupe α varie de $20 \cdot 10^{-6}\,°C^{-1}$ à $40 \cdot 10^{-6}\,°C^{-1}$.

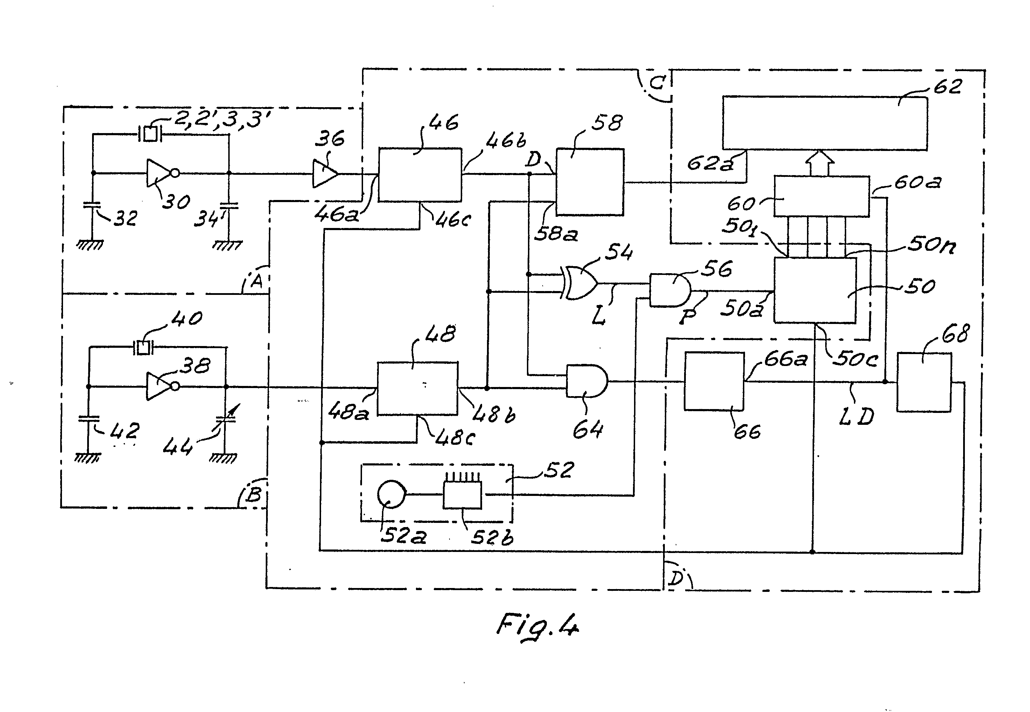

En se référant maintenant à la figure 4, il va être décrit un mode de réalisation du circuit de traitement électronique qui, avec le résonateur, constitue le thermomètre.

D'une manière générale, le thermomètre comprend : un circuit oscillant de mesure A incluant le capteur de température constitué par le résonateur ; un circuit oscillant de référence B ; un circuit de comparaison C ; et un circuit d'affichage et de remise à zéro D.

Le circuit oscillant de mesure A comprend l'élément vibrant 2 de mesure décrit précédemment et le circuit d'entretien de type connu. Ce circuit comprend l'amplificateur 30 avec, en contre-réaction, l'élément vibrant 2. Des capacités 32 et 34 sont montées respectivement entre l'entrée et la sortie de l'amplificateur d'une part et la masse d'autre part. Ce circuit est complété par un amplificateur d'isolation 36.

Le circuit oscillant de référence B a une structure sensiblement identique et comprend l'amplificateur 38 avec, en contre-réaction, l'élément oscillant de référence 40. Ce circuit comprend, en outre, les capacités 42 et 44. Il faut observer que la capacité 44 est réglable pour pouvoir adapter la fréquence de référence comme cela sera expliqué ultérieurement.

Des moyens de comparaison C comprennent essentiellement deux compteurs par M (M : nombre entier) référencés respectivement 46 et 48, un troisième compteur 50 et un générateur 52 d'impulsions électriques à fréquence réglable. Plus précisément, les entrées d'horloge 46a et 48a des compteurs 46 et 48 reçoivent les impulsions délivrées par les circuits oscillants A et B. Les sorties 46b et 48b des compteurs 46 et 48 sont reliées aux deux entrées d'une porte OU EXCLUSIF 54. La source de fréquence variable 52 est constituée, de préférence, par un générateur 52a qui délivre un signal impulsionnel à fréquence élevée fixe et dont la sortie est reliée à un diviseur programmable 52b. A la sortie du diviseur 52b, le signal a donc la fréquence $f_C$ réglée par le taux de division du diviseur 52b. Bien entendu, le générateur 52 pourrait aussi être constitué par un générateur à fréquence commandable.

La sortie du générateur 52 et la sortie de la porte 54 sont reliées respectivement aux deux entrées d'une porte ET 56. L'entrée d'horloge 50a du troisième compteur 50 est reliée à la sortie de la porte ET 56. Les sorties des compteurs 46 et 48 sont reliées respectivement à l'entrée D et à l'entrée d'horloge 58a d'un bistable D 58 dont la fonction est de donner le signe de la température mesurée par l'élément oscillant, c'est-à-dire l'ordre dans lequel se présente le front de montée des signaux délivrés respectivement par les compteurs 46 et 48.

Le circuit d'affichage et de remise à zéro D comprend un latch 60 dont les entrées sont reliées aux sorties binaires $50_1$ à $50_n$ du compteur 50. Le latch 60 est connecté lui-même à un ensemble de décodage et d'affichage 62. L'ensemble 62 d'affichage comprend une entrée particulière 62a reliée à la sortie du bistable 58 pour afficher le signe de la température par rapport 0 °C.

Les sorties 46b et 48b des compteurs 46 et 48 sont également respectivement reliées aux deux entrées d'une porte ET 64. La sortie de la porte 64 est reliée à l'entrée du monostable 66 qui est du type « non réexcitable ». La sortie 66a du monostable 66 délivre un signal de commande LD qui est appliqué

6

d'une part à l'entrée du deuxième monostable 68 et d'autre part à l'entrée de commande 60a du latch 60. Le monostable 68 délivre une impulsion de remise à zéro qui est appliquée aux entrées de remise à zéro 46c, 48c et 50c respectivement des compteurs 46, 48 et 50.

Le fonctionnement du thermomètre qui vient d'être décrit est le suivant :

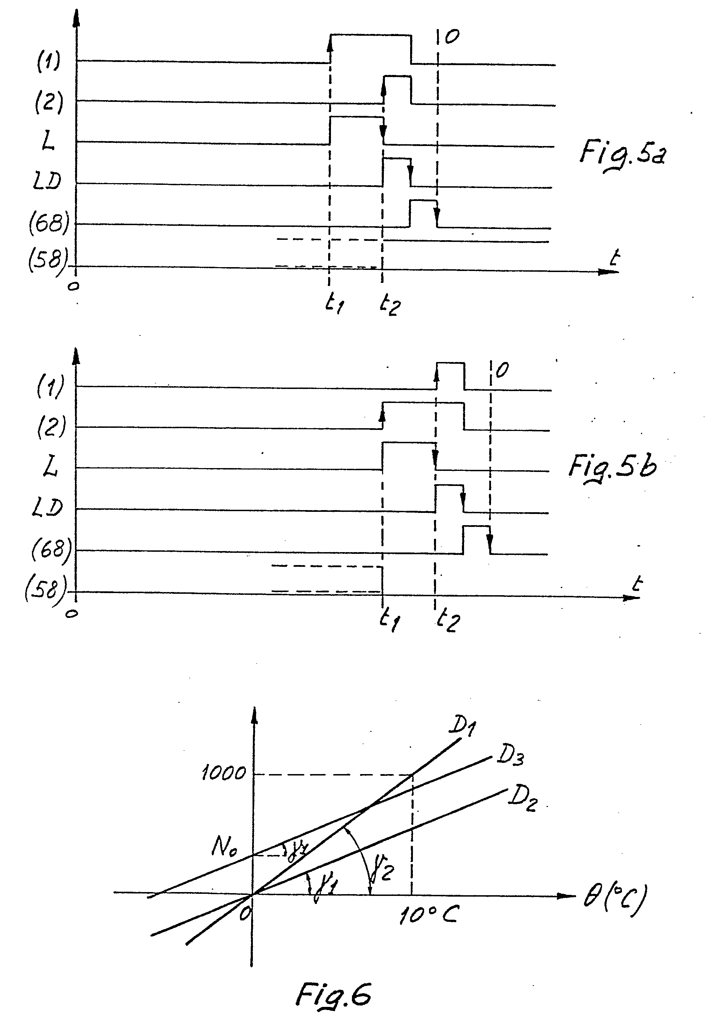

Le compteur 46 compte les impulsions délivrées par l'oscillateur de mesure A. Lorsque le compteur a compté M impulsions, sa sortie passe à l'état logique 1, comme le montre le diagramme (1) des figures 5a et 5b.

Simultanément, le compteur 48 compte les impulsions délivrées par l'oscillateur de référence B. Lorsque le compteur a compté M impulsions, sa sortie passe au niveau logique 1, comme le montre le diagramme (2) des figures 5a et 5b. Soit $T_t$ le temps que met le compteur 46 à compter M impulsions et $T_r$ le temps que met le compteur 48 à compter M impulsions. Le signal L qui apparaît à la sortie de la porte OU EXCLUSIF 54 a un niveau logique 1 entre les instants $t_1$ et $t_2$ où les sorties des compteurs 46 et 48 passent à l'état logique 1. Le signal L a donc le niveau logique 1 pendant une durée $T_t - T_r$. Dans le cas de la figure 5a, le temps $T_t$ est inférieur au temps $T_r$, c'est-à-dire que la température à mesurer est supérieure à la température de référence. Au contraire, dans le cas de la figure 5b, le temps $T_t$ est supérieur au temps $T_r$, donc la température à mesurer est inférieure à la température de référence.

Le compteur 50 reçoit sur son entrée 50a les impulsions du signal P délivré par la porte ET 56. Il reçoit donc les impulsions délivrées par le générateur 52 entre les instants $t_1$ et $t_2$. En conséquence, à partir de l'instant $t_2$ (fig. 5a), le contenu du compteur 50 est égal au nombre d'impulsions N émises par le générateur 52 pendant le temps $T_t - T_r$. Ce nombre N est représentatif de la température T à mesurer comme cela sera expliqué ultérieurement. De plus, à l'instant $t_2$ (fig. 5a), la porte ET 64 voit sa sortie passer au niveau logique 1, pendant le temps $T_1$ fixé par sa constante de temps, ce qui donne le signal LD. Le signal LD délivré par le monostable 66 commande le déblocage du latch 60 et le nombre N d'impulsions est appliqué au système de décodage et d'affichage 62. Le front descendant du signal LD provoque le changement d'état de la sortie du monostable 68 qui passe au niveau logique 1 pendant le temps $\tau_2$ fixé par sa constante de temps. Cette impulsion remet à zéro les compteurs 46, 48 et 50. Lorsqu'il apparaît le front descendant de cette impulsion, le dispositif est prêt pour une nouvelle mesure de température.

En résumé, le compteur 50 compte les impulsions du signal délivré par le générateur d'impulsions 52 dans la fenêtre limitée par les instants $t_1$ et $t_2$. Le nombre N d'impulsions représente la température T à mesurer, la relation entre N et T étant sensiblement linéaire grâce au choix du résonateur.

Le réglage du thermomètre est réalisé en agissant sur la fréquence $f_C$ du signal délivré par le générateur 52 et sur la valeur de la capacité 44 de l'oscillateur de référence.

La figure 6 montre plusieurs droites pour différents réglages $D_1$, $D_2$ et $D_3$ qui donnent la relation sensiblement linéaire entre la température T et le nombre N d'impulsions comptées par le compteur 50. La modification de la fréquence $f_C$ permet de modifier le rapport de proportionnalité entre la température T et le nombre d'impulsions comptées. Elle agit donc sur la valeur de l'angle $\gamma$ ($\gamma_1$, $\gamma_2$.....) Au contraire, une action sur la capacité 44 modifie la valeur de référence, c'est-à-dire le nombre No d'impulsions correspondant à la température 0 °C. Sur la figure 6, la droite $D_1$ correspond à un réglage optimal puisque No = 0 pour T = 0 °C et que l'angle $\gamma = \gamma_2$ correspond à une bonne sensibilité du thermomètre.

Pour régler la valeur de la capacité 44, le thermomètre (oscillateur A) est placé dans une ambiance à 0 °C. Le temps $T_t$ correspond donc à la température To. La capacité 44 est modifiée jusqu'à ce que le compteur 50 ne compte aucune impulsion du générateur 52. Dans cette situation, $T_r = T_t$ et l'oscillateur B délivre donc un signal à une fréquence de référence correspondant à T = 0 °C. Ce réglage est bien sûr indépendant du réglage de la fréquence $f_C$.

La valeur de l'angle $\gamma$ est réglée en agissant sur la fréquence $f_C$ sans modifier la capacité 44.

Si le résonateur a un coefficient $\alpha$ du premier degré de $30 \cdot 10^{-6}$ °C et si M (taux de comptage des compteurs 46 et 48) vaut $2 \cdot 10^5$, un accroissement de la température de 1 °C entraîne une diminution du temps de comptage de 10 µs si donc la fréquence $f_c$ est choisie égale à 10 MHz (période $T_c = 0 \cdot 1$ µs) N vaudra 100. En conséquence, si la fréquence du résonateur à T = 0 °C est égale à 300 kHz, un tel thermomètre pourra mesurer des écarts de température de 0.01 °C.

Dans l'exemple considéré deux mesures successives seront séparées par un intervalle de temps inférieur ou égal à 400 ms si les constantes de temps $\tau_1$ et $\tau_2$ des monostables 66 et 68 sont choisies judicieusement.

Le circuit qui vient d'être décrit ne constitue qu'un exemple de réalisation particulièrement bien adapté au problème à résoudre. Il est clair cependant que d'autres circuits pourraient être utilisés. Il suffit que ces circuits comportent un dispositif qui permette de mesurer la différence de fréquence entre le signal délivré par l'oscillateur de mesure et le signal délivré par l'oscillateur de référence, et un dispositif pour afficher cette mesure de préférence sous forme numérique.

Il résulte de la description précédente que, grâce au choix du résonateur et de son mode d'excitation, le thermomètre objet de l'invention a une structure simple et donc peu coûteuse.

Il apparaît également clairement que l'usinage du quartz est simplifié, si on choisit un diapason ou d'un barreau dans lequel la coupe utilisée est relativement proche d'une coupe Z (mode de réalisation des figures 1, 1a, 3). Le circuit de traitement a une structure simple et permet un réglage aisé du thermomètre.

De plus, du fait que le résonateur travaille à une fréquence de l'ordre de 300 kHz, la consommation électrique est réduite.

En outre, malgré ces simplifications multiples, le thermomètre permet d'obtenir une mesure de température avec une bonne résolution (0,01 °C) et une périodicité de mesure suffisamment faible (de l'ordre de 400 ms) pour contrôler des variations rapides de température.

## Revendications

1. Thermomètre à quartz comprenant

un résonateur (2 ; 2') comportant un barreau en quartz (8 ; 21) présentant deux faces principales (9, 9') sensiblement parallèles entre elles, parallèles à la longueur du barreau et limitées par des bords et une section droite sensiblement rectangulaire avec un grand côté formant les faces principales du barreau et un petit côté perpendiculaire auxdites faces, ainsi qu'une pluralité d'électrodes (12, 12' ; 13, 13' ; 22-25, 22'-25') pour créer dans le cristal de quartz un champ électrique faisant vibrer ledit barreau et délivrer un signal par ledit résonateur ; et

un circuit électronique (A-D) pour traiter le signal délivré par le résonateur et fournir à sa sortie une grandeur représentant la température à laquelle est soumis ledit résonateur, caractérisé par le fait que

la longueur dudit barreau (8 ; 21) est sensiblement parallèle à l'axe optique X du cristal de quartz ; que

lesdites faces principales (9, 9') sont perpendiculaires à un axe Z' faisant avec l'axe optique Z du cristal de quartz un angle θ compris entre + 30° et − 30° ; que

le rapport entre les longueurs du petit et du grand côté de ladite section droite du barreau est compris entre 0,1 et 0,8 ; et que

lesdites électrodes (12, 12', 13, 13' ; 22-25, 22'-25') sont disposées sur lesdites faces principales du barreau en quartz, parallèlement à la longueur de ce dernier, au voisinage desdits bords, et sont polarisées de façon que ledit champ électrique fasse vibrer ledit barreau en torsion ;

ledit résonateur (2 ; 2') délivrant alors un signal dont les variations de fréquence sont une fonction sensiblement linéaire de ladite température.

2. Thermomètre à quartz selon la revendication 1, caractérisé par le fait que le barreau (21) est divisé en deux demi-barreaux (21a, 21b) par un plan (N) perpendiculaire à la longueur dudit barreau ; qu'un premier groupe de quatre électrodes (22, 22', 23, 23') est disposé sur l'un (21a) des demi-barreaux, deux électrodes disposées sur une même face principale et adjacentes à des bords opposés étant portées à des potentiels différents et deux électrodes disposées chacune sur l'une des faces principales et se faisant face étant portées auxdits potentiels différents ; qu'un second groupe de quatre électrodes (24, 24', 25, 25') est disposé de la même manière que le premier groupe sur l'autre demi-barreau (21b) ; et que deux électrodes disposées chacune sur l'un des demi-barreaux, symétriquement par rapport audit plan (N) sont portées auxdits potentiels différents.

3. Thermomètre à quartz selon la revendication 1, caractérisé par le fait que ledit résonateur comprend un autre barreau, les deux barreaux étant sensiblement identiques, disposés symétriquement par rapport à un plan et constituant les deux branches (8, 10) d'un diapason (2) ; et par le fait qu'un groupe de quatre électrodes (12, 12', 13, 13', resp. 14, 14', 15, 15') est disposé sur chaque branche (8, resp. 10) du diapason, deux électrodes disposées sur une même face principale d'une branche et adjacentes à des bords opposés étant portées à deux potentiels différents et deux électrodes disposées chacune sur l'une des faces principales de cette branche et se faisant face étant portées auxdits potentiels différents.

4. Thermomètre à quartz selon la revendication 3, caractérisé par le fait que deux électrodes disposées chacune sur l'une des branches (8, 10) du diapason (2), symétriquement par rapport audit plan sont portées au même potentiel.

5. Thermomètre à quartz selon l'une quelconque des revendications 2 à 4, caractérisé par le fait que le rapport entre les longueurs du petit et du grand côté de la section droite est compris entre 0,4 et 0,8.

6. Thermomètre à quartz selon l'une quelconque des revendications 2 à 5, caractérisé par le fait que ledit angle θ est compris entre + 10° et − 10°.

7. Thermomètre à quartz selon l'une quelconque des revendications 2 à 6, caractérisé par le fait que ledit angle θ est sensiblement égal à + 2° et que le rapport entre le petit et le grand côté de la section droite est sensiblement égal à 0,68.

8. Thermomètre à quartz comprenant

un résonateur (3, 3') comportant un barreau en quartz (8' ; 150) présentant deux faces principales (102, 102') sensiblement parallèles entre elles et parallèles à la longueur dudit barreau, deux flancs (110, 112) également sensiblement parallèles à ladite longueur et une section droite sensiblement rectangulaire avec un grand côté disposé selon lesdites faces principales et un petit côté selon lesdits flancs, ainsi qu'une pluralité d'électrodes (106, 106', 118, 118' ; 152-158, 152'-158') pour créer dans le cristal de quartz un champ électrique faisant vibrer ledit élément et délivrer un signal par ledit résonateur ; et

un circuit électronique (A-D) pour traiter le signal délivré par le résonateur et fournir à sa sortie une grandeur représentant la température à laquelle est soumis ledit résonateur,
caractérisé par le fait que
la longueur dudit barreau (8' ; 150) est sensiblement parallèle à l'axe optique X du cristal de quartz ; que
lesdites faces principales (102, 102') sont perpendiculaires à un axe Z' faisant avec l'axe optique Z du cristal de quartz un angle θ compris entre + 30° et + 50° ou entre − 30° et − 50° ; que
le rapport entre les longueurs du petit et du grand côté de ladite section droite du barreau est compris entre 0,1 et 0,8 ; et que
chaque face principale et chaque flanc (110, 112) est muni d'au moins une électrode (106, 106', 118, 118' ; 152-158', 152'-158') disposée parallèlement à la longueur dudit barreau, lesdites électrodes étant polarisées de manière que ledit champ électrique fasse vibrer ledit barreau en torsion,
ledit résonateur (3, 3') délivrant alors un signal dont les variations de fréquence sont une fonction sensiblement linéaire de ladite température.

9. Thermomètre à quartz selon la revendication 8, caractérisé par le fait que le barreau (150) est divisé en deux demi-barreaux (150a, 150b) par un plan (N') perpendiculaire à la longueur dudit barreau, qu'un premier groupe de quatre électrodes (152, 152', 154, 154') est disposé sur l'un (150a) des demi-barreaux, les électrodes (152, 152') de ce premier groupe qui sont disposées sur les faces principales du barreau étant portées à un premier potentiel et les électrodes (154, 154') disposées sur les flancs à un second potentiel, et qu'un second groupe de quatre électrodes (156, 156', 158, 158') est disposé de la même manière que le premier groupe sur l'autre demi-barreau (150b), les électrodes de ce second groupe disposées sur lesdites faces principales étant portées audit second potentiel et les électrodes disposées sur les flancs audit premier potentiel.

10. Thermomètre à quartz selon la revendication 8, caractérisé par le fait que le résonateur comprend un autre barreau, les deux barreaux étant sensiblement identiques, disposés symétriquement par rapport à un plan et constituant les deux branches (8', 10') d'un diapason (3), et par le fait que chaque face principale et chaque flanc de chacune des deux branches est muni d'une électrode, les électrodes (106, 106', 108, 108') des faces principales d'une même branche étant portées à un même potentiel et les électrodes (118, 118', 120, 120') des flancs de cette branche étant portées à un autre potentiel.

11. Thermomètre à quartz selon la revendication 10, caractérisé par le fait que les électrodes des faces principales, respectivement des flancs, de l'une des branches (8', 10') sont portées au même potentiel que les électrodes des flancs, respectivement des faces principales, de l'autre branche.

12. Thermomètre à quartz selon l'une quelconque des revendications 1 à 11, caractérisé par le fait que ledit circuit électronique comprend :
un oscillateur de référence (B) à fréquence réglable ;
des moyens (C) pour comparer la fréquence du signal délivré par ledit résonateur (2, 2', 3, 3') et ledit oscillateur de référence et produire une indication de température à partir de l'écart entre les fréquences de ces signaux ; et
des moyens (D) pour afficher ladite indication de température.

13. Thermomètre à quartz selon la revendication 12, caractérisé par le fait que lesdits moyens de comparaison (C) comprennent :
des moyens (46) pour compter M impulsions délivrées par ledit résonateur et pour délivrer un premier signal lorsque les M impulsions sont comptées ;
des moyens (48) pour compter simultanément M impulsions délivrées par ledit oscillateur de référence et pour délivrer un deuxième signal lorsque les M impulsions sont comptées ;
des moyens (52) pour délivrer un signal de mesure à fréquence réglable ; et
des moyens (50) pour compter les impulsions dudit signal de mesure entre lesdits premier et deuxième signaux.

## Claims

1. A quartz thermometer having :
a resonator (2 ; 2') comprising a quartz bar (8 ; 21) having two main surface (9, 9') which are substantially parallel to each other, which are parallel to the length of the bar and which are limited by edges, and having a substantially rectangular cross-section with the large sides thereof forming the main surfaces of the bar and the small sides thereof being at right angles to said surfaces, and further comprising a plurality of electrodes (12, 12' ; 13, 13' ; 22-25, 22'-25') for setting up in the quartz crystal an electric field such as to cause the bar to vibrate and a signal to be issued by the resonator ; and
an electronic circuit (A-D) for processing the signal issued by the resonator and supplying on its output a magnitude representative of the temperature to which the resonator is subjected ;
characterized in that
the length of the bar (8 ; 21) is substantially parallel to the optical axis of the quartz crystal ; that

said main surfaces (9, 9') are at right angles to an axis Z' forming with the optical axis Z of the quartz crystal an angle $\theta$ of from $+30°$ to $-30°$ ; that

the lengths of the small and large sides of the cross-section of the bar are in a ratio of from 0.1 to 0.8 ; and that

the electrodes (12, 12' ; 13, 13' ; 22-25, 22'-25') are disposed on the main surfaces of the quartz bar, parallel to the length thereof, adjacent said edges, and are polarized such that said electric field will cause the bar to vibrate torsionally ;

the resonator (2 ; 2') then issuing a signal whose frequency variations are a substantially linear function of said temperature.

2. A quartz thermometer according to claim 1, characterized in that the bar (21) is divided into two half-bars (21a, 21b) by a plane (N) which is perpendicular to the length of the bar ; that a first group of four electrodes (22, 22', 23, 23') is disposed on one (21a) of the half-bars, two electrodes both disposed on one main surface, adjacent opposite edges, being raised to different potentials and two electrodes each disposed on one main surface, opposite one another, being raised to said different potentials ; that a second group of four electrodes (24, 24', 25, 25') is disposed in the same manner as the first group on the other half-bar (21b) ; and that two electrodes each disposed on one of the half-bars, symmetrically in relation to said plane (N), are raised to said different potentials.

3. A quartz thermometer according to claim 1, characterized in that said resonator comprises a further bar, the two bars being substantially identical, being symmetrically disposed with respect to a plane and forming the two branches (8, 10) of a tuning fork (2) ; and in that a group of four electrodes (12, 12', 13, 13' and 14, 14', 15, 15', respectively) is disposed on each branch (8 and 10, respectively) of the tuning fork, with two electrodes both disposed on one main surface of one branch, adjacent opposite edges, being raised to two different potentials and with two electrodes each disposed on one of the main surfaces of said one branch, opposite one another, being raised to said different potentials.

4. A quartz thermometer according to claim 3, characterized in that two electrodes each disposed on one branch (8, 10) of the tuning fork (2), symmetrically with respect to said plane, are raised to the same potential.

5. A quartz thermometer according to any one of claims 2 to 4, characterized in that the lengths of the small and large sides of the cross-section are in a ratio ranging from 0.4 to 0.8.

6. A quartz thermometer according to any one of claims 2 to 5, characterized in that said angle $\theta$ ranges from $+10°$ to $-10°$.

7. A quartz thermometer according to any one of claims 2 to 6, characterized in that said angle $\theta$ is substantially equal to $+2°$ and that the small and large sides of the cross-section are in a ratio of substantially 0.68.

8. A quartz thermometer having

a resonator (3, 3') comprising a quartz bar (8' ; 150) having two main surfaces (102, 102') which are substantially parallel to each other and which are parallel to the length of the bar, two flanks (110, 112) which are also substantially parallel to said length, and having a substantially rectangular cross-section with the large sides thereof disposed in accordance with the main surfaces and the small sides there of disposed in accordance with said flanks, and further comprising a plurality of electrodes (106, 106', 118, 118' ; 152-158, 152'-158') for setting up in the quartz crystal an electric field such as to cause said element to vibrate and a signal to be delivered by the resonator ; and

an electronic circuit (A-D) for processing the signal delivered by the resonator and supplying on its output a magnitude representative of the temperature to which the resonator is subjected ;

characterized in that

the length of the bar (8' ; 150) is substantialy parallel to the optical axis X of the quartz crystal ; that said main surfaces (102, 102') are at right angles to an axis Z' forming with the optical axis Z of the quartz crystal an angle $\theta$ of from $+30°$ to $+50°$ or from $-30°$ to $-50°$ ; that

the lengths of the small and large sides of the cross-section of the bar are in a ratio of from 0.1 to 0.8 ; and that

each main surface and each flank (110, 112) is provided with at least one electrode (106, 106', 118, 118' ; 152-158, 152'-158') disposed parallel to the length of the bar, said electrodes being polarized such that said electric field will cause the bar to vibrate torsionally,

the resonator (3, 3') then issuing a signal whose frequency variations are a substantially linear function of said temperature.

9. A quartz thermometer according to claim 8, characterized in that the bar (150) is divided into two half-bars (150a, 150b) by a plane (N') which is perpendicular to the length of the bar, that a first group of four electrodes (152, 152', 154, 154') is disposed on one (150a) of the half-bars, the electrodes (152, 152') of this first group that are disposed on the main surfaces of the bar being raised to a first potential and the electrodes (154, 154') disposed on the flanks being raised to a second potential, and in that a second group of four electrodes (156, 156', 158, 158') is disposed in the same way as the first group on the other half-bar (150b), the electrodes of this second group that are disposed on said main surfaces being raised to said second potential and the electrodes that are disposed on the flanks being raised to said first potential.

10. A quartz thermometer according to claim 8, characterized in that the resonator comprises a further bar, the two bars being substantially identical, being symmetrically disposed with respect to a plane and forming the two branches (8′, 10′) of a tuning fork (3), and in that each main surface and each flank of each of the two branches is provided with an electrode, the electrodes (106, 106′, 108, 108′) of the main surfaces of one branch being raised to one potential and the electrodes (118, 118′, 120, 120′) of the flanks of said one branch being raised to another potential.

11. A quartz thermometer according to claim 10, characterized in that the electrodes of the main surfaces and the electrodes of the flanks of one branch (8′, 10′) are respectively raised to the same potential as the electrodes of the flanks and the electrodes of the main surfaces of the other branch.

12. A quartz thermometer according to any one of claims 1 to 11, characterized in that the electronic circuit comprises :

a reference oscillator (3) having an adjustable frequency ;

means (C) for comparing the frequency of the signals isued by the resonator (2, 2′, 3, 3′) and by the reference oscillator and for producing a temperature indication from the difference between the frequencies of these signals ; and

means (D) for displaying said temperature indication.

13. A quartz thermometer according to claim 12, characterized in that the comparing means (C) comprise :

means (46) for counting M pulses issued by the resonator and for issuing a first signal when M pulses have been counted ;

means (48) for simultaneously counting M pulses issued by the reference oscillator and for issuing a second signal when M pulses have been counted ;

means (52) for issuing a measurement signal at an adjustable frequency ; and

means (50) for counting the pulses of the measurement signal between said first and second signals.

## Ansprüche

1. Quarzthermometer, umfassend

einen Resonator (2 ; 2′) der einen Quarzstab (8 ; 21) aufweist, der zwei Hauptflächen (9, 9′), die im wesentlichen parallel zueinander, parallel zur der Länge des Stabes und durch Ränder und einen im wesentlichen rechteckigen Querschnitt mit einer großen Seite, die die Hauptflächen des Stabes bildet, und einer kleinen Seite senkrecht zu den besagten Flächen begrenzt sind, ebenso wie eine Vielzahl von Elektroden (12, 12′ ; 13, 13′ ; 22-25, 22′-25′) besitzt, um in dem Quarzkristall ein elektrisches Feld zu erzeugen, das den besagten Stab schwingen läßt, und ein Signal durch den besagten Resonator zu liefern ; und

einen elektronischen Schaltkreis (A-D) zum Verarbeiten des von dem Resonator gelierferten Signals und zum Liefern einer Größe an seinem Ausgang, die die Temperatur darstellt, der der besagte Resonator unterworfen ist,

dadurch gekennzeichnet, daß

die Länge des besagten Stabes (8 ; 21) im wesentlichen parallel zur optischen Achse X des Quarzkristalls verläuft ; daß

die besagten Hauptflächen (9, 9′) senkrecht zu einer Achse Z′ verlaufen, die mit der optischen Achse Z des Quarzkristalls einen Winkel θ zwischen + 30° und − 30° bildet ; daß

das Verhältnis zwischen den Längen der kleinen und der großen Seite des besagten Querschnitts des Stabes zwischen 0,1 und 0,8 liegt ; und daß

die besagten Elektroden (12, 12′ ; 13, 13′ ; 22-25 ; 22′-25′) auf den besagten Hauptflächen des Quarzstabes parallel zur Länge des letzteren benachbart zu den besagten Rändern angeordnet und derart polarisiert sind, daß das besagte elektrische Feld den Stab Torsionsschwingungen ausführen läßt ;

wobei der besagte Resonator (2 ; 2′) hierauf ein Signal liefert, dessen Frequenzänderungen eine im wesentlichen lineare Funktion der besagten Temperatur sind.

2. Quarzthermometer nach Anspruch 1, dadurch gekennzeichnet, daß der Stab (21) in zwei Halbstäbe (21a, 21b) durch eine Ebene (N) senkrecht zur Länge des besagten Stabes geteilt ist ; daß eine erste Gruppe von vier Elektroden (22, 22′, 23, 23′) auf einem (21a) der Halbstäbe angeordnet ist, wobei zwei Elektroden auf einer gleichen Hauptfläche und benachbart von gegenüberliegenden Rändern angeordnet sind und auf verschiedenen Potentialen gehalten sind und zwei Elektroden jeweils auf einer der Hauptflächen angeordnet und sich gegenüberliegend auf den genannten verschiedenen Potentialen gehalten sind ; daß eine zweite Gruppe von vier Elektroden (24, 24′, 25, 25′) in der gleichen Weise wie die erste Gruppe auf dem anderen Halbstab (21b) angeordnet ist ; und daß zwei Elektroden, jede auf einem der Halbstäbe symmetrisch in Bezug auf die besagte Ebene (N) angeordnet, auf den besagten verschiedenen Potentialen gehalten sind.

3. Quarzthermometer nach Anspruch 1, dadurch gekennzeichnet, daß der besagte Resonator einen weiteren Stab aufweist, wobei die beiden Stäbe im wesentlichen identisch, symmetrisch in Bezug auf eine Ebene angeordnet sind und die beiden Zinken (8, 10) einer Stimmgabel (2) bilden ; und daß eine Gruppe von vier Elektroden (12, 12′, 13, 13′ bzw. 14, 14′, 15, 15′) auf jeder Zinke (8 bzw. 10) der Stimmgabel angeordnet ist, wobei zwei Elektroden auf einer gleichen Hauptfläche einer Zinke und banachbart zu gegenüberliegenden Rändern auf zwei verschiedenen Potentialen gehalten angeordnet sind und zwei Elektroden jede auf einer der Hauptflächen dieser Zinke und sich gegenüberliegend auf den besagten verschiedenen Potentialen gehalten sind.

4. Quarzthermometer nach Anspruch 3, dadurch gekennzeichnet, daß die beiden Elektroden, jede auf einer der Zinken (8, 10) der Stimmgabel (2) symmetrisch in Bezug zu der besagten Ebene angeordnet, auf dem gleichen Potential gehalten sind.

5. Quarzthermometer nach einem der Ansprüche 2 bis 4, dadurch gekennzeichnet, daß das Verhältnis zwischen den Längen der kleinen und der großen Seite des Querschnitts zwischen 0,4 und 0,8 liegt.

6. Quarzthermometer nach einem der Ansprüche 2 bis 5, dadurch gekennzeichnet, daß der besagte Winkel θ zwischen + 10° und − 10° liegt.

7. Quarzthermometer nach einem der Ansprüche 2 bis 6, dadurch gekennzeichnet, daß der besagte Winkel θ im wesentlichen gleich + 2° ist und daß das Verhältnis zwischen der kleinen und der großen Seite des Querschnitts im wesentlichen gleich 0,68 ist.

8. Quarzthermometer, umfassend

einen Resonator (3, 3'), der einen Quarzstab (8' ; 150) aufweist, der zwei Hauptflächen (102, 102'), die im wesentlichen parallel zueinander und parallel zur Länge des besagten Stabes sind, zwei Seitenflächen (110, 112), die ebenfalls im wesentlichen parallel zu der besagten Länge sind, und einen Querschnitt, der im wesentlichen rechteckig mit einer großen Seite, die gemäß den besagten Hauptflächen angeordnet ist, und einer kleinen Seite gemäß den besagten Seitenflächen ist, ebenso wie eine Vielzahl von Elektroden (106, 106', 118, 118' ; 152-158, 152'-158') zum Erzeugen eines elektrischen Feldes in dem Quarzkristall, das das besagte Element schwingen läßt, und zum Liefern eines Signals durch den besagten Resonator besitzt ; und

einen elektronischen Schaltkreis (A-D) zum Verarbeiten des von dem Resonator gelieferten Signals und zum Liefern einer Größe an seinem Ausgang, die die Temperatur darstellt, der der besagte Resonator unterworfen ist,

dadurch gekennzeichnet, daß

die Länge des besagten Stabes (8' ; 150) im wesentlichen parallel zur optischen Achse X des Quarzkristalls verläuft ; daß

die besagten Hauptflächen (102, 102') senkrecht zu einer Achse Z' verlaufen, die zur optischen Achse Z des Quarzkristalls einen Winkel θ zwischen + 30° und + 50° oder zwischen − 30° und − 50° bildet ; daß

das Verhältnis zwischen den Längen der kleinen und der großen Seite des besagten Querschnitts des Stabes zwischen 0,1 und 0,8 liegt ; und daß

jede Hauptfläche und jede Seitenfläche (110, 112) mit wenigstens einer Elektrode (106, 106', 118, 118' ; 152-158, 152'-158') versehen ist, die parallel zur Länge des besagten Stabes angeordnet ist, wobei die besagten Elektroden derart polarisiert sind, daß das besagte elektrische Feld den besagten Stab Torsionsschwingungen ausführen läßt,

wobei der besagte Resonator (3, 3') hierauf ein Signal liefert, dessen Frequenzänderungen eine im wesentlichen lineare Funktion der besagten Temperatur sind.

9. Quarzthermometer nach Anspruch 8, dadurch gekennzeichnet, daß der Stab (150) durch eine Ebene (N') senkrecht zur Länge des besagten Stabes in zwei Halbstäbe (150a, 150b) geteilt ist, daß eine erste Gruppe von vier Elektroden (152, 152', 154, 154') auf dem einen (150a) der Halbstäbe angeordnet ist, wobei die Elektroden (152, 152') dieser ersten Gruppe, die auf den Hauptflächen des Stabes angeordnet sind, sich auf einem ersten Potential befinden und die Elektroden (154, 154'), die auf den Seitenflächen angeordnet sind, sich auf einem zweiten Potential befinden, und daß eine zweite Gruppe von vier Elektroden (156, 156', 158, 158') in der gleichen Weise wie die erste Gruppe auf dem anderen Halbstab (150b) angeordnet sind, wobei die Elektroden dieser zweiten Gruppe, die auf den besagten Hauptflächen angeordnet sind, sich auf dem besagten zweiten Potential und die Elektroden, die auf den Seitenflächen angeordnet sind, sich auf dem besagten ersten Potential befinden.

10. Quarzthermometer nach Anspruch 8, dadurch gekennzeichnet, daß der Resonator einen weiteren Stab aufweist, wobei die beiden Stäbe im wesentlichen identisch, symmetrisch in Bezug auf eine Ebene angeordnet sind und die beiden Zinken (8', 10') einer Stimmgabel (3) bilden, und daß jede Hauptfläche und jede Seitenfläche jeder der beiden Zinken mit einer Elektrode versehen ist, wobei die Elektroden (106, 106', 108, 108') von Hauptflächen einer gleichen Zinke sich auf einem gleichen Potential und die Elektroden (118, 118', 120, 120') von Seitenflächen dieser Zinke auf einem anderen Potential befinden.

11. Quarzthermometer nach Anspruch 10, dadurch gekennzeichnet, daß die Elektroden von Hauptflächen bzw. Seitenflächen von der einen der Zinken (8', 10') sich auf dem gleichen Potential befinden wie die Elektroden von Seitenflächen bzw. Hauptflächen der anderen Zinke.

12. Quarzthermometer nach einem der Ansprüche 1 bis 11, dadurch gekennzeichnet, daß der besagte elektronische Schaltkreis umfaßt :

einen Vergleichsoszillator (B) mit einstellbarer Frequenz ;

Mittel (C) zum Vergleichen der Frequenz des von dem besagten Resonator (2, 2', 3, 3') gelieferten Signals und des besagten Vergleichsoszillators und zum Erzeugen einer Temperaturangabe aus der Abweichung zwischen den Frequenzen dieser Signale ; und

Mittel (D) zum Anzeigen der besagten Temperaturangabe.

13. Quarzthermometer nach Anspruch 12, dadurch gekennzeichnet, daß die besagten Mittel zum Vergleichen (C) umfassen :

Mittel (46) zum Zählen von M Impulsen, die von dem besagten Resonator geliefert werden, und zum Liefern eines ersten Signals, wenn die M Impulse gezählt sind ;

Mittel (48) zum gleichzeitigen Zählen von M Impulsen, die von dem besagten Vergleichsoszillator geliefert werden, und zum Liefern eines zweiten Signals, wenn die M Impulse gezählt sind ;

Mittel (52) zum Liefern eines Taktsignals mit einstellbarer Frequenz ; und

Mittel (50) zum Zählen der Impulse des besagten Taktsignals zwischen dem besagten ersten und zweiten Signal.

Fig.1

0 048 689

Fig.1a

Fig. 2

Fig. 3

2

Fig.4

Fig.5a

Fig.5b

Fig.6

4

Fig.7

Fig.7a

Fig.8

Fig.10

Fig.9